# EUROPEAN PATENT APPLICATION

(11) **EP 4 394 857 A1**
(43) Date of publication of application: **03.07.2024**
(21) Application number: 23194431.5
(22) Date of filing: 31.08.2023
(51) Int. Cl.: H01L 21/8234, H01L 27/088, H01L 29/775, H01L 29/417, H01L 21/768

(54) **GATE CUT, AND SOURCE AND DRAIN CONTACTS**

(30) Priority: 28.12.2022 US 202218090048
(71) Applicant: INTEL Corporation, Santa Clara, CA 95054 (US)
(72) Inventor: Patel, Reken, Portland, 97203 (US); Puls, Conor P., Portland, 97229 (US); Ganesan, Krishna, Portland, 97229 (US); Matsubayashi, Akitomo, Beaverton, 97006 (US); Paredes, Diana Ivonne, Portland, 97229 (US); Ferdous, Sunzida, Portland, 97210 (US); Greene, Brian, Portland, 97229 (US); Syed, Lateef Uddin, Portland, 97229 (US); Horak, Kyle T., Portland, 97229 (US); Hu, Lin, Portland, 97209 (US); Bowonder, Anupama, Portland, 97229 (US); Ghosh, Swapnadip, Hillsboro, 97124 (US); Rai, Amritesh, Tigard, 97224 (US); Subramanian, Shruti, Hillsboro, 97124 (US); Freeman, Gordon S., Hood River, 97031 (US)
(74) Representative: Goddar, Heinz J.

(57) **Abstract**

An integrated circuit includes a first device (101a), and a laterally adjacent second device (101a). The first device includes a first body of semiconductor material extending laterally from a first source or drain region (130a), a first gate structure on the first body, and a first contact (138a) extending vertically upward from the first source or drain region. The second device includes a second body of semiconductor material extending laterally from a second source or drain region (130b), a second gate structure on the second body, and a second contact (138b) extending vertically upward from the second source or drain region. A gate cut structure (114) including dielectric material is laterally between the first gate structure and the second gate structure, and also laterally between the first contact (138a) and the second contact (138b). A third contact (140) extends laterally from the first contact to the second contact and passes over the gate cut structure.

## Description

### FIELD OF THE DISCLOSURE

The present disclosure relates to integrated circuits, and more particularly, to source or drain contacts of transistor devices.

### BACKGROUND

As integrated circuits continue to scale downward in size, a number of challenges arise. For example, as transistors are packed more densely in a given device layer, the interconnection and routing of devices, as well as achieving low contact resistance, becomes challenging. Accordingly, there remain a number of non-trivial challenges with respect to forming semiconductor devices.

### BRIEF DESCRIPTION OF THE DRAWINGS

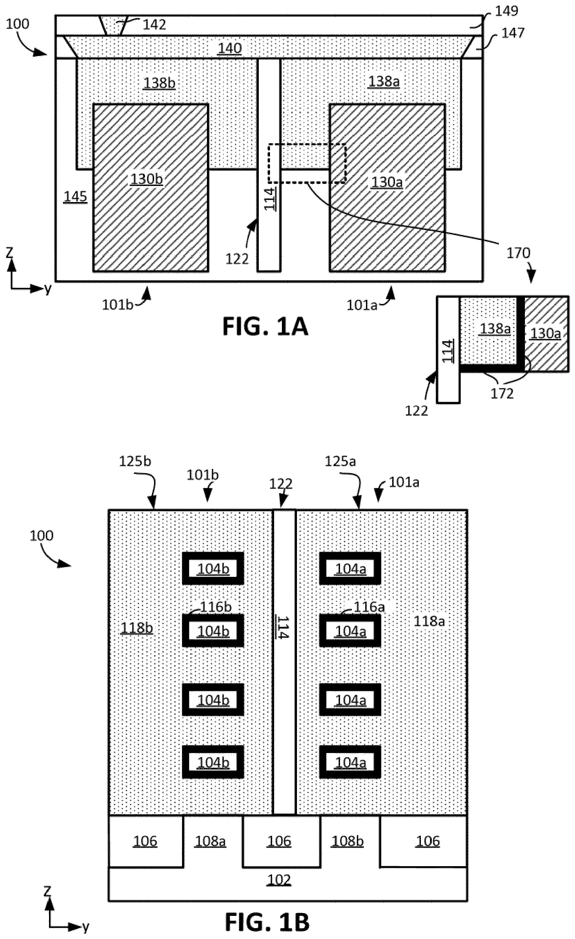

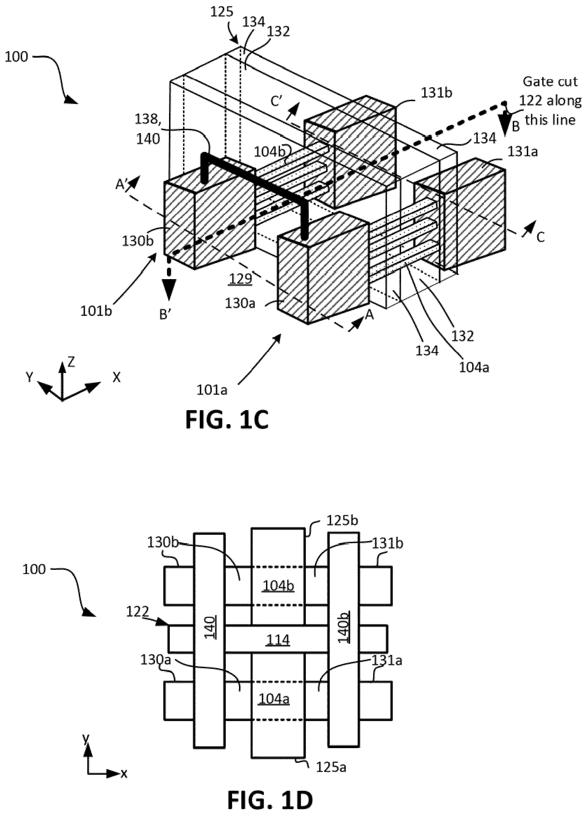

**Figs. 1A, 1B****,** **1C**, and **1D** illustrate various views of an integrated circuit structure comprising (i) a first semiconductor device including a first source or drain region, a first channel region comprising semiconductor material extending from the first source or drain region, a first gate structure on the first channel region, and a first contact extending vertically upward from the first source or drain region, (ii) a second semiconductor device including a second source or drain region, a second channel region comprising semiconductor material extending from the second source or drain region, a second gate structure on the second channel region, and a second contact extending vertically upward from the second source or drain region, and (iii) a third contact extending laterally from the first contact to the second contact, wherein a gate cut comprising dielectric material (A) extends laterally between the first gate structure and the second gate structure and also (B) extends laterally between the first contact and the second contact, according to an embodiment of the present disclosure.

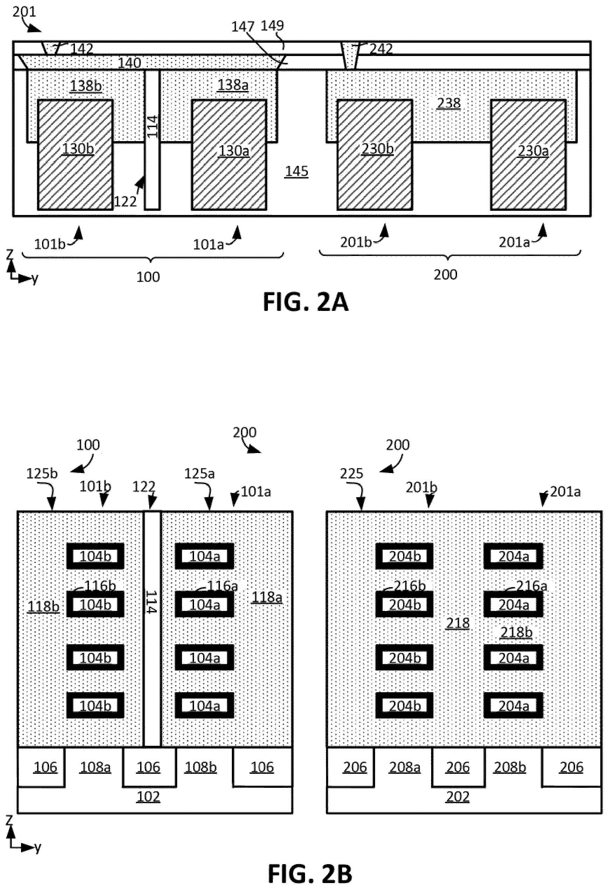

**Figs. 2A** and **2B** illustrate cross-sectional views of an integrated circuit structure that includes a first portion that is similar to the integrated circuit structure of Figs. 1A-1D, and also includes a second portion comprising a continuous and monolithic source or drain contact for two corresponding source or drain regions, without any gate cut extending through the continuous and monolithic source or drain contact, according to an embodiment of the present disclosure.

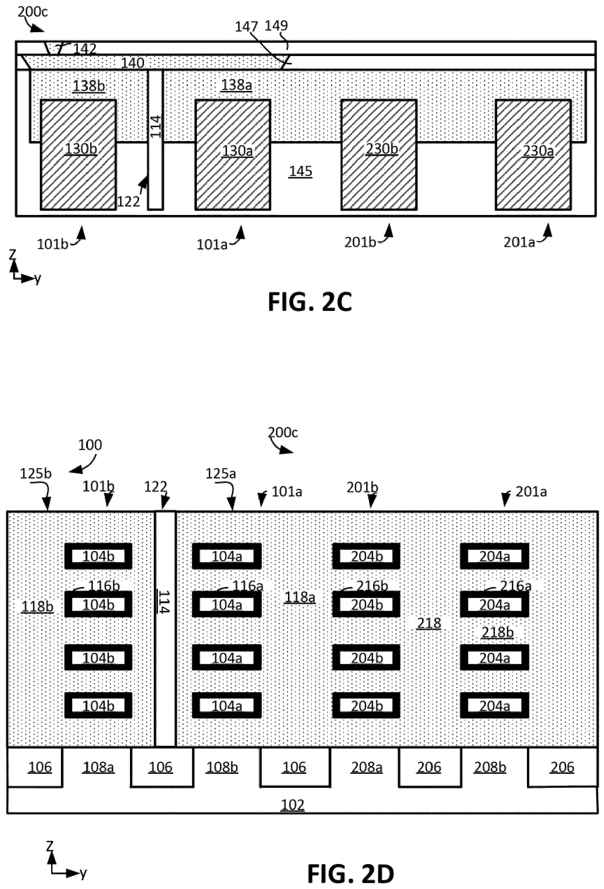

**Figs. 2C and 2D** illustrate various cross-sectional views of an integrated circuit structure is at least in part similar to the structure of Figs. 1A-1D, and where the second contact of the integrated circuit structure of Figs. 2C and 2D is a continuous and monolithic contact that extends vertically upward from a plurality of source or drain regions, according to an embodiment of the present disclosure.

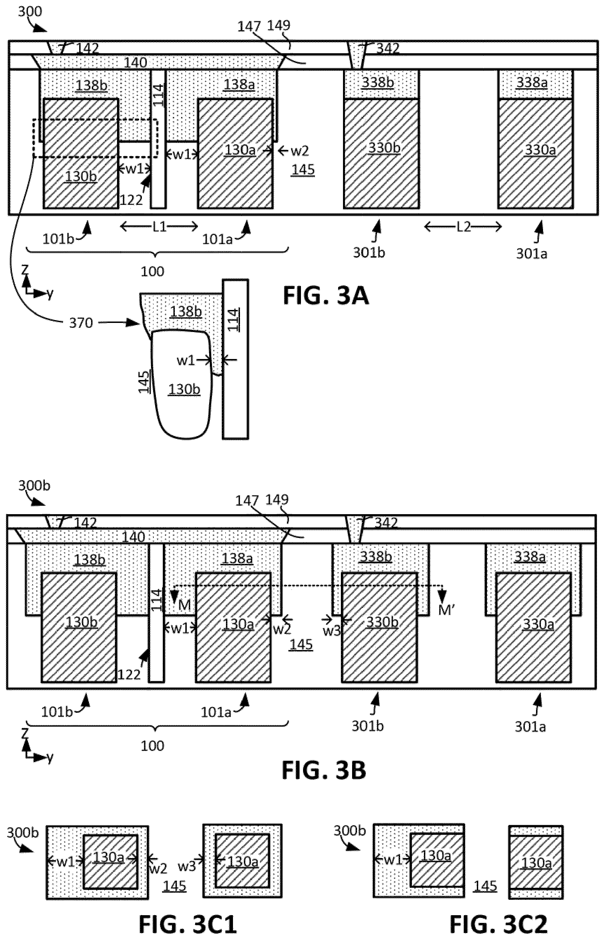

**Fig. 3A** illustrate a cross-sectional view of an integrated circuit structure that includes (i) a first source or drain region, (ii) a first source or drain contact in contact with the first source or drain region, (iii) a second source or drain region, (iv) a second source or drain contact in contact with the second source or drain region, wherein the first source or drain contact is on a top surface and a side surface of the first source or drain region, and wherein the second source or drain contact is only on a top surface of the second source or drain region, according to an embodiment of the present disclosure.
Figs. 3B and 3C1 illustrate cross-sectional and plan views, respectively, of an integrated circuit structure that includes (i) a first source or drain region, (ii) a first source or drain contact in contact with the first source or drain region, (iii) a second source or drain region, (ii) a second source or drain contact in contact with the second source or drain region, wherein a portion of the first source or drain contact on side surfaces of the first source or drain contact has a maximum width of w1, wherein a portion of the second source or drain contact on side surfaces of the second source or drain contact has a maximum width of w3, and wherein the width w1 is substantially greater than the width w3, according to an embodiment of the present disclosure.
Fig. 3C2 illustrates an example plan view of the structure of Fig. 3B, according to another embodiment of the present disclosure.

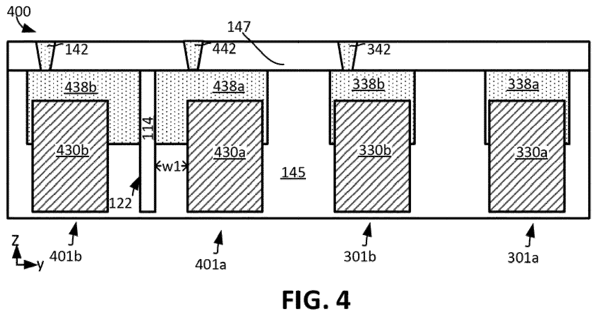

**Fig. 4** illustrates a cross-sectional view of an integrated circuit structure that is at least in part similar to the integrated circuit structure of Figs. 3B and 3C1, wherein a gate cut is laterally between a first source or drain contact and a second source or drain contact, and wherein the first source or drain contact and the second source or drain contact are not conjoined by a bridge contact, according to an embodiment of the present disclosure.

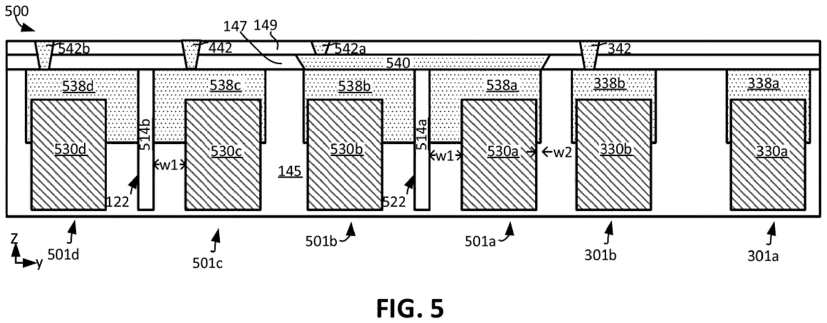

**Fig. 5** illustrates a cross-sectional view of an integrated circuit structure in which (i) a first source or drain contact and a second source or drain contact are laterally separated by a first gate cut and conjoined by a bridge contact, (ii) a third source or drain contact and a fourth source or drain contact are laterally separated by a second gate cut and are not conjoined by any bridge contact, and (iii) fifth and sixth source or drain contacts that are not adjacent to a gate cut, according to an embodiment of the present disclosure.

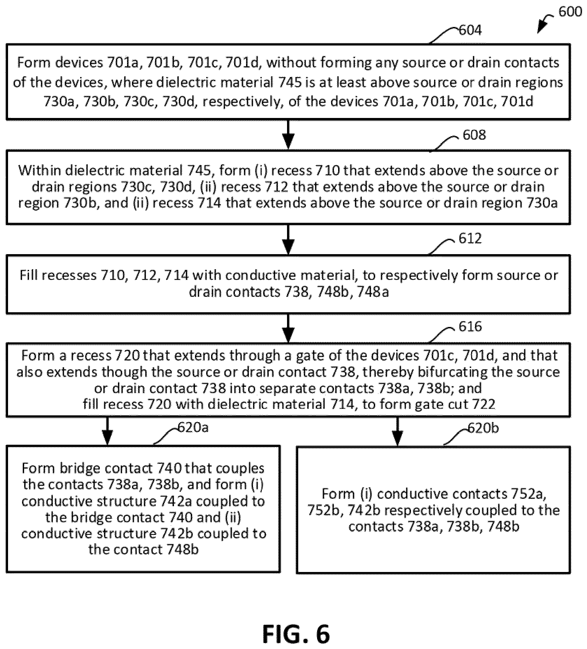

**Fig. 6** illustrates a flowchart depicting a method of forming any of the integrated circuit structures of Figs. 1A-5, in accordance with an embodiment of the present disclosure.

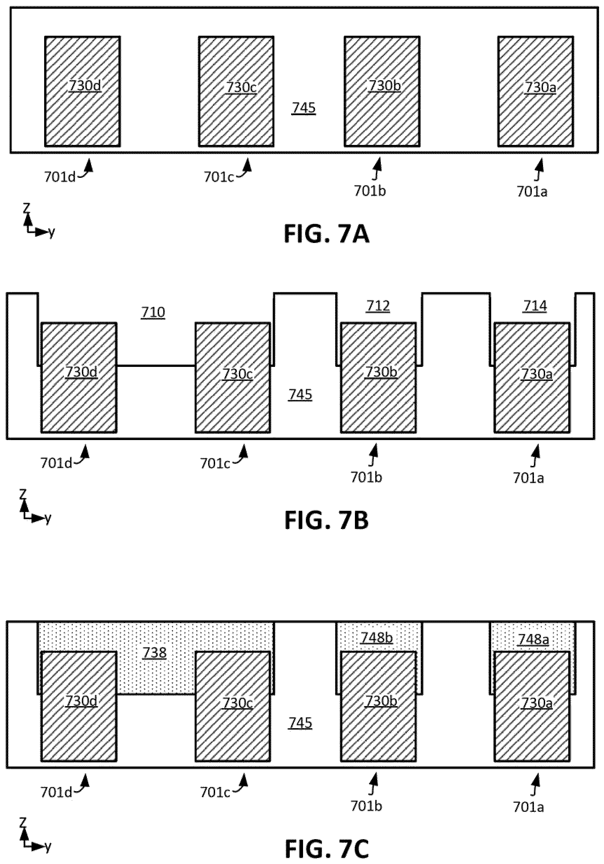

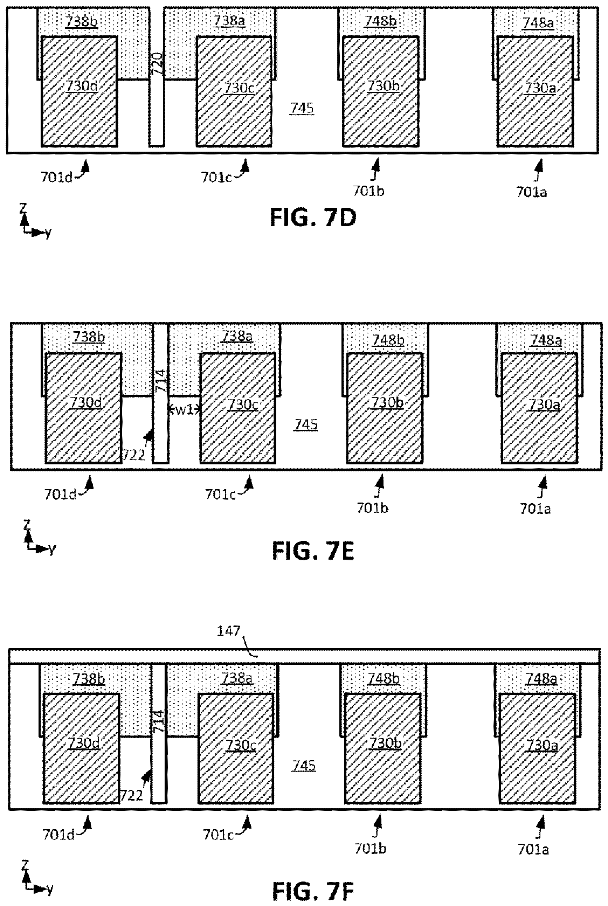

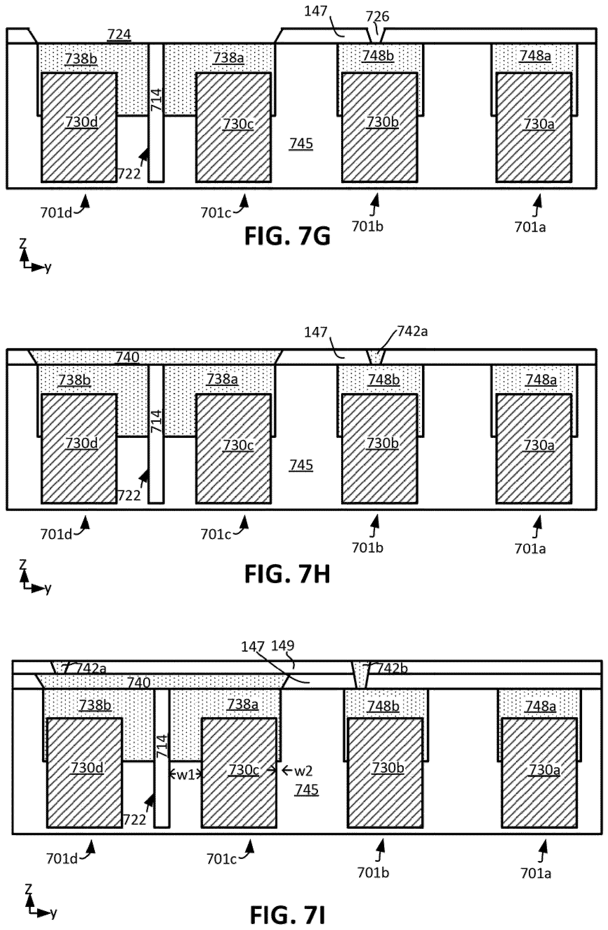

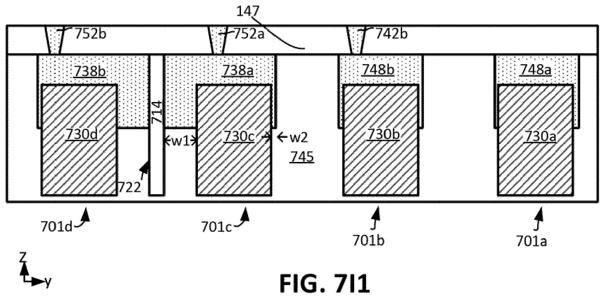

**Figs. 7A, 7B, 7C****,** **7D, 7E, 7F****,** **7G, 7H**, 7I, and 7I1 collectively illustrate cross-sectional views of an integrated circuit structure in various stages of processing in accordance with the methodology of Fig. 6, in accordance with an embodiment of the present disclosure.

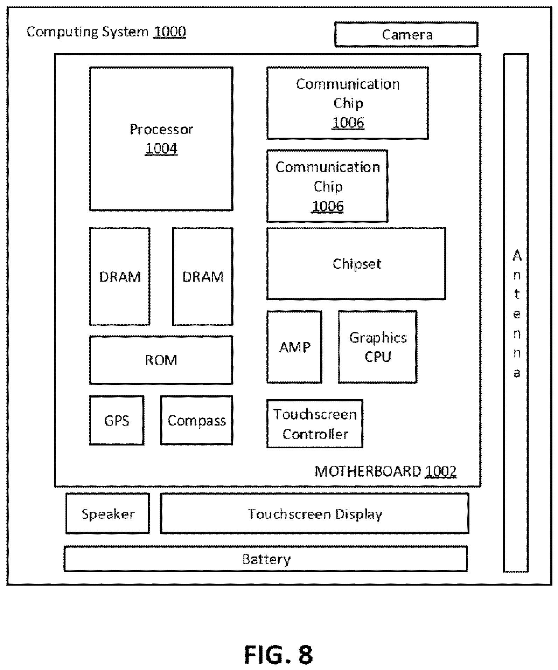

**Fig. 8** illustrates a computing system implemented with integrated circuit structures (such as the integrated circuit structures illustrated in Figs. 1A-5) formed using the techniques disclosed herein, in accordance with some embodiments of the present disclosure.

As will be appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles (e.g., some features may have tapered sidewalls and/or rounded corners), and some features may have surface topology or otherwise be non-smooth, given real world limitations of the processing equipment and techniques used. Likewise, while the thickness of a given first layer may appear to be similar in thickness to a second layer, in actuality that first layer may be much thinner or thicker than the second layer; same goes for other layer or feature dimensions.

### DETAILED DESCRIPTION

Techniques are described herein for providing source and drain contacts in transistor devices. In some examples, a continuous and monolithic contact is initially formed on neighboring source or drain regions, and a gate cut is then formed to bifurcate that monolithic contact into two separate contacts. In some such cases, the bifurcated contacts may be conjoined or otherwise reconnected by an overlying bridge conductor or other interconnect feature(s). By initially forming a larger continuous and monolithic contact over multiple source or drain regions, a higher quality contact may be made to each underlying source or drain region. Then, a gate cut can be used to break contact in locations where desired. Also, a bridging contact can be subsequently added to reconnect any contacts that actually should be connected. Numerous configurations and variations will be apparent in light of this disclosure.

### General Overview

As previously noted above, routing signals and/or power to and/or from individual transistors has become even more challenging, due to diminishing device sizes. For example, the spacing available for source and drain contacts is getting smaller and smaller, due to further scaling of the diffusion regions. As such, contact resistance is becoming a more and more challenging issue.

Thus, and in accordance with an embodiment of the present disclosure, techniques are described herein for forming source and drain contacts in transistor devices. In some examples, a continuous and monolithic contact is initially formed on neighboring source or drain (diffusion) regions. The contact deposition may deposit on top and side surfaces of one or more of the diffusion regions. Subsequently, the continuous and monolithic contact is divided into two or more separate contacts, by forming one or more corresponding gate cuts that pass through the continuous and monolithic contact. Each such gate cut also passes between neighboring diffusion regions. In some such cases, an overlying bridge contact may be provided to reconnect diffusion contacts that are severed during a gate cut process. In this sense, the techniques provided herein can be used to opportunistically use the gate cut process to reduce contact resistance between a source or drain contact and a corresponding source or drain region. Note that the gate cut is formed after the diffusion contacts are provided. Thus, some depositions attributable to the diffusion contact process may not be on the gate cut. For instance, some diffusion contacts may include a liner or barrier layer that is deposited prior to deposition of a conductive fill material. In such cases, the liner or barrier layer will not extend along the gate cut sidewall as it would otherwise do if the gate cut structure was present when the contact trench was formed and the liner or barrier layer was deposited.

In an example, assume a first device laterally adjacent to a second device, and a first source or drain region of the first device is laterally adjacent to a second source or drain region of the second device. The first and second devices may be, for example, metal oxide semiconductor (MOS) transistors (e.g., non-planar MOS transistors), such as tri-gate (e.g., finFET) or gate-all-around (GAA) transistors, although other transistor topologies and types could also benefit from the techniques provided herein. Thus, the channel regions of individual devices may comprise nanoribbons, nanowires, nanosheets, or a fin-based structure. Initially (e.g., prior to formation of the gate cut) a monolithic and continuous source or drain contact structure may be in contact with both the first and second source or drain regions. For example, the continuous source or drain contact structure is above the first source or drain region and the second source or drain region. Similarly, a continuous gate structure may be provided initially for both the first and second devices.

In one such embodiment, subsequently, during a gate cut formation process, a gate cut comprising dielectric material is formed, and which extends through the continuous gate structure, to provide two separate gate structures for the two corresponding devices. However, in an example, the gate cut process is non-selective, and the gate cut thus also extends though the continuous source or drain contact structure, to bifurcate the continuous source or drain contact structure into (i) a first source or drain contact for the first device, and (ii) a second source or drain contact for the second device.

In some such examples, the design of the circuit may, however, dictate that the first and second source or drain contacts be electrically coupled. Accordingly, a bridge contact may be subsequently formed, which laterally extends from an upper surface of the first source or drain contact to an upper surface of the second source or drain contact, thereby reconnecting or otherwise coupling the two source or drain contacts. The bridge contact extends above the dielectric material of the gate cut.

In some such examples, the source or drain contact may be only on an upper surface, but not be on sidewalls, of the corresponding source or drain region. This may help to increase a lateral gap between adjacent source or drain contacts, e.g., to reduce chances of electrical shorting between adjacent contacts. However, in other examples, the initially formed continuous source or drain contact structure can be on one or more sidewalls of the corresponding source or drain regions, in addition to top surfaces of those source or drain regions. For example, during formation of the above discussed monolithic and continuous source or drain contact structure (e.g., through which the gate cut structure later extends), a space laterally between the first source or drain region and the second source or drain region is at least in part filled with the continuous source or drain contact structure. So, the continuous source or drain contact structure is on upper surfaces of the first and second source or drain regions, and also on sidewalls of the first and second source or drain regions. For instance, in one such example, the first source or drain region has (i) a first sidewall facing the second source or drain region, and (ii) an opposing second sidewall. Similarly, the second source or drain region has (i) a third sidewall facing the first source or drain region, and (ii) an opposing fourth sidewall. In an example, a portion of the continuous source or drain contact structure is on the first sidewall of the first source or drain region, and is also on the third sidewall of the second source or drain region. Accordingly, even after the continuous source or drain contact structure is bifurcated by the gate cut, a portion of the first source or drain contact may remain on the first sidewall of the first source or drain, and similarly, a portion of the second source or drain contact may remain on the third sidewall of the second source or drain. Having a source or drain contact on a sidewall (in addition to an upper surface) of a corresponding source or drain region effectively increases contact surface area and may therefore help to decrease contact resistance, without a corresponding increase in capacitance, thereby resulting in performance gain.

In an example, the above discussed at least in part wrapping of the source or drain contact on a sidewall of the corresponding source or drain region is independent of formation of the above discussed bridge contact. Thus, irrespective of whether the bridge contact is formed or not, a source or drain contact adjacent to a gate cut may be on a sidewall (as well as an upper surface) of the corresponding source or drain region. Thus, while the bridge contact between the first and second source or drain regions may be formed in one embodiment, the bridge contact may be absent between the first and second source or drain regions in another embodiment - however, for both cases, each of the first and second source or drain regions may be on a corresponding sidewall of a corresponding source or drain region. Moreover, note that the process margin for a process to deposit a larger diffusion contact across first and second diffusion regions and that is later divided into two diffusion contacts by a gate cut may be more forgiving than the process margin associated with a process designed to land a smaller diffusion contact on a single diffusion region. Similarly, device performance variation may also be reduced by the process to deposit a larger diffusion contact across first and second diffusion regions and that is later divided into two diffusion contacts by the gate cut.

The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For example, in some embodiments, such tools may be used to detect a first transistor device having a first source or drain region, a laterally adjacent second transistor device having a second source or drain region, a first source or drain contact of the first source or drain region, a second source or drain contact of the second source or drain region, a gate cut structure comprising dielectric material laterally between the first and second source or drain contacts. In some examples, a bridge contact extends from an upper surface of the first source or drain contact to an upper surface of the second source or drain contact, although the bridge contact may be absent in another example. In an example, the first source or drain region includes a first sidewall facing the second source or drain region, and an opposing second sidewall. The first source or drain contact is on the first sidewall of the first source or drain region (e.g., along with an upper surface of the first source or drain region). In an example, the first source or drain contact may be absent on the second sidewall of the first source or drain region. In another example, a portion of the first source or drain contact may be on the second sidewall, but a width of the first source or drain contact on the second sidewall may be less than a width of the first source or drain contact on the first sidewall by at least 2 nanometers (nm), or at least 4 nm, or at least 6 nm, or at least 8 nm, or at least 10 nm. Numerous configurations and variations will be apparent in light of this disclosure.

### Architecture

Figs. 1A and 1B illustrate cross-sectional views, and Fig. 1C illustrate a perspective view, and Fig. 1D illustrates a plan view of an integrated circuit structure 100 comprising (i) a first semiconductor device 101a including a first source or drain region 130a, a first channel region 104a comprising semiconductor material extending from the first source or drain region 130a, a first gate structure 125a on the first channel region 104a, and a first contact 138a extending vertically upward from the first source or drain region 130a, (ii) a second semiconductor device 101b including a second source or drain region 130b, a second channel region 104b comprising semiconductor material extending from the second source or drain region 130b, a second gate structure 125b on the second channel region 104b, and a second contact 138b extending vertically upward from the second source or drain region 130b, and (iii) a third contact 140 extending laterally from the first contact 138a to the second contact 138b, wherein a gate cut 122 comprising dielectric material 114 (A) extends laterally between the first gate structure 125a and the second gate structure 125b and also (B) extends laterally between the first contact 138a and the second contact 138b, according to an embodiment of the present disclosure.

The cross-sectional view of Fig. 1A is taken across the source or drain regions 130a, 130b of the semiconductor devices, and illustrates cross-sectional views of the source or drain regions 130a, 130b, and is taken along line A-A' of the perspective view of Fig. 1C. The cross-sectional view of Fig. 1B is taken across the gate structures 125a, 125b, and illustrates cross-sectional views of the channel regions 104a, 104b, and is taken along line C-C' of the perspective view of Fig. 1C.

Note that the perspective view of Fig. 1C doesn't illustrate various components of the structure 100. For example, instead of showing the gate cut 122, Fig. 1C illustrates a dotted line B-B' along which the gate cut 122 is to be formed. Furthermore, for example, the actual structure of the contacts 138a, 138b, 140 are not illustrated in Fig. 1C - rather, these contacts are schematically illustrated using a thick line in Fig. 1C. Fig. 1C is mainly to provide relative locations of the various source or drain regions, the channel regions 104, and the gate structures.

In the plan or top view of Fig. 1D, the channel regions 104a, 104b (e.g., which may be nanoribbons 104a, 104b, respectively, in one example) are illustrated using dotted lines, as the corresponding gate structures 125a, 125b, respectively, would be on and above the nanoribbons 104a, 104b, and hence, the nanoribbons would not be visible in the plan view of Fig. 1D. Also, note that the contacts 138a, 138b are not visible in the plan view of Fig. 1D, as the contact 140 is above the contacts 138a, 138b, and the contact 140 is visible in the plan view.

In an example, each of semiconductor devices 101a, 101b may be non-planar metal oxide semiconductor (MOS) transistors, such as tri-gate (e.g., finFET) or gate-all-around (GAA) transistors, although other transistor topologies and types could also benefit from the techniques provided herein. The illustrated embodiments herein use the GAA structure including nanoribbons 104a, 104b as channel regions. The term nanoribbon may also encompass other similar GAA channel region shapes such as nanowires or nanosheets. Note that the nanoribbons of a device may be replaced by a fin-based structured in one example, to form a finFET device.

The various illustrated semiconductor devices represent a portion of an integrated circuit that may contain any number of similar semiconductor devices. Thus, although two example devices 101a, 101b are illustrated, there may be additional devices.

Each of devices 101a, 101b includes corresponding one or more nanoribbons 104a, 104b, respectively, that extend parallel to one another along an X-axis direction, between source and drain regions 130 (e.g., a first direction into and out of the page in the cross-section view of Fig. 1B). Nanoribbons 104 are one example of semiconductor regions or semiconductor bodies that extend between corresponding source and drain regions. The semiconductor material of nanoribbons 104 may be formed from substrate 102, in an example. In some embodiments, devices 101a, 101b may each include semiconductor regions in the shape of fins that can be, for example, native to substrate 102 (formed from the substrate itself), such as silicon (Si) fins etched from a bulk silicon substrate. Alternatively, the fins can be formed of material deposited onto an underlying substrate. In one such example case, a blanket layer of silicon germanium (SiGe) can be deposited onto a silicon substrate, and then patterned and etched to form a plurality of SiGe fins extending from that substrate. In another such example, non-native fins can be formed in a so-called aspect ratio trapping based process, where native fins are etched away so as to leave fin-shaped trenches which can then be filled with an alternative semiconductor material (e.g., group IV or III-V material). In still other embodiments, the fins include alternating layers of material (e.g., alternating layers of silicon and SiGe) that facilitates forming of the illustrated nanoribbons 104 during a gate forming process where one type of the alternating layers is selectively etched away so as to liberate the other type of alternating layers within the channel region, so that a gate-all-around (GAA) process can then be carried out. Again, the alternating layers can be blanket deposited and then etched into fins or deposited into fin-shaped trenches. In an example, the nanoribbons 104 comprise an appropriate semiconductor material, such as silicon (Si), silicon germanium (SiGe), or another appropriate semiconductor material.

As can be seen, devices 101 are formed on a substrate 102. Any number of semiconductor devices 101 can be formed on substrate 102, but two are illustrated here as an example. Substrate 102 can be, for example, a bulk substrate including group IV semiconductor material (such as silicon, germanium, or silicon germanium), group III-V semiconductor material (such as gallium arsenide, indium gallium arsenide, or indium phosphide), and/or any other suitable material upon which transistors can be formed. Alternatively, substrate 102 can be a semiconductor-on-insulator substrate having a desired semiconductor layer over a buried insulator layer (e.g., silicon over silicon dioxide). Alternatively, substrate 102 can be a multilayer substrate or superlattice suitable for forming nanowires or nanoribbons (e.g., alternating layers of silicon and SiGe, or alternating layers indium gallium arsenide and indium phosphide). Any number of substrates can be used. In some embodiments, a lower portion of (or all of) substrate 102 is removed and replaced with one or more backside interconnect layers to form backside signal and power routing, during a backside process.

As can further be seen, adjacent semiconductor devices are separated by a dielectric fill 106. Dielectric fill 106 provides shallow trench isolation (STI) between any adjacent semiconductor devices. Dielectric fill 106 can be any suitable dielectric material, such as silicon oxide (SiO), silicon nitride (SiN), silicon carbide (SiC), silicon oxycarbide (SiOC), silicon oxycarbonitride (SiOCN), or silicon oxynitride (SiON), for example.

The structure 100 comprises sub-fin regions 108a, 108b, such that the devices 104a, 104b each include a corresponding sub-fin region 108. According to some embodiments, sub-fin regions 108 comprise the same semiconductor material as substrate 102 and is adjacent to dielectric fill 106. According to some embodiments, nanoribbons 104 (or other semiconductor bodies, such as nanowires, nanosheets, or fin-based structures) extend between source and drain regions (illustrated in Fig. 1C) in the first direction (e.g., along the X-axis of Fig. 1C). For example, nanoribbons 104a provide an active channel region for a corresponding transistor device 101a, and nanoribbons 104b provide an active channel region for a corresponding transistor device 101b.

Referring to Figs. 1C and 1D, the device 101a comprises a source or drain region 130a and another source or drain region 131a, with one or more nanoribbons 104a extending from the source or drain region 130a to the source or drain region 131a. Similarly, the device 101b comprises a source or drain region 130b and a source or drain region 131b, with one or more nanoribbons 104b extending from the source or drain region 130b to the source or drain region 131b. Note that the source or drain regions 130a, 130b are on a same first side of the gate structures 125a, 125b, and the source or drain regions 131a, 131b are on an opposing second side of the gate structures 125a, 125b, as illustrated in Fig. 1C and 1D. As discussed, the gate structures 125a, 125b are illustrated to be continuous in Fig. 1C - however, a gate cut 122 separates the gate structures 125a, 125b, and the gate cut 122 is not illustrated in Fig. 1C. Each source or drain region 130 or 131 may be either a source region, or a drain region, e.g., based on an implementation of the structure 100 as a part of a circuit.

According to some embodiments, source or drain regions 130a, 130b, 131a, 131b are epitaxial regions that are provided using an etch-and-replace process. In other embodiments source or drain regions 130, 131 could be, for example, implantation-doped native portions of the semiconductor fins or substrate. Any semiconductor materials suitable for source and drain regions can be used (e.g., group IV and group III-V semiconductor materials). Source or drain regions may include multiple layers such as liners and capping layers to improve contact resistance. In any such cases, the composition and doping of source or drain regions may be the same or different, depending on the polarity of the transistors. In an example, for instance, one of the devices 101a, 101b is a p-type MOS (PMOS) transistor, an adjacent one of the devices is an n-type MOS (NMOS) transistor, and so on. Any number of source and drain configurations and materials can be used.

According to some embodiments, individual gate structures 125a, 125b extend over corresponding nanoribbons 104 along a second direction (e.g., in the direction of the Y-axis and across the page of Fig. 1B). For example, as illustrated in Fig. 1B, gate structure 125a extends over and is on the nanoribbons 104a of the device 101a; and gate structure 125b extends over and is on the nanoribbons 104b of the device 101b. Note that in an example, a gate structure (such as the gate structure 125a) may be on nanoribbons of more than one device, such as on nanoribbons 104a of the device 101a, as well as nanoribbon of another device that is laterally adjacent to the device 101 (where in this example, the device 101a may be laterally between the other device and the device 101b).

In one embodiment, each gate structure 125a, 125b includes a gate dielectric 116 that wraps around middle portions of each nanoribbon 104, and a gate electrode 118 that wraps around the gate dielectric 116. For example, gate structure 125a includes gate dielectric 116a wrapping around nanoribbons 104a, and gate electrode 118a. Similarly, gate structure 125b includes gate dielectric 116b wrapping around nanoribbons 104b, and gate electrode 118b.

In some embodiments, the gate dielectric 116 may include a single material layer or multiple stacked material layers. The gate dielectric 116 may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. The high-k dielectric material (e.g., hafnium oxide) may be doped with an element to affect the threshold voltage of the given semiconductor device. According to some embodiments, the doping element used in gate dielectric 116 is lanthanum. In some embodiments, the gate dielectric can be annealed to improve its quality when high-k dielectric material is used. In some embodiments, the gate dielectric 116 includes a first layer (e.g., native oxide of nanoribbons, such as silicon dioxide or germanium oxide or SiGe-oxide) on the nanoribbons, and a second layer of high-k dielectric (e.g., hafnium oxide) on the first layer. The gate dielectric 116 is present around middle portions of each nanoribbon. In an example, the gate dielectric 116 may also be present over sub-fin 108, and/or on inner sidewalls of inner gate spacers (not illustrated).

The gate electrode 118a of the gate structure 125a wraps around middle portions of individual nanoribbons 104a, and the gate electrode 118b of the gate structure 125b wraps around middle portions of individual nanoribbons 104b. Note that the middle portion of each nanoribbon 104 is between a corresponding first end portion and a second end portion, where the first end portions of the nanoribbons of a stack is wrapped around by a corresponding first inner gate spacer 134, and where the second end portions of the nanoribbons of the stack is wrapped around by a corresponding second inner gate spacer 134. Inner gate spacers 134 can include any suitable dielectric material, such as silicon oxide or silicon nitride

In one embodiment, one or more work function materials may be included around the nanoribbons 104. Note that work function materials are called out separately, but may be considered to be part of the gate electrodes. In this manner, a gate electrode 118 may include multiple layers or components, including one or more work function materials, gate fill material, capping or resistance-reducing material, to name a few examples. In some embodiments, a p-channel device may include a work function metal having titanium, and an n-channel device may include a work function metal having tungsten or aluminum, although other material and combination may also be possible. In some other embodiments, the work function metal may be absent around one or more nanoribbons. In still other embodiments, there may be insufficient room for any gate fill material, after deposition of work function material (i.e., a given gate electrode may be all work function material and no fill material). In an example, the gate electrodes 118 may include any sufficiently conductive material, such as a metal, metal alloy, or doped polysilicon. The gate electrodes may include a wide range of materials, such as polysilicon or various suitable metals or metal alloys, such as aluminum, tungsten, titanium, tantalum, copper, cobalt, molybdenum, titanium nitride, or tantalum nitride, for example. Numerous gate structure configurations can be used along with the techniques provided herein, and the present disclosure is not intended to be limited to any particular such configurations.

As further shown in this example, adjacent gate structures 125a, 125b are separated laterally by a gate cut 122, which acts like a dielectric barrier between gate structures 125a, 125b. The gate cut 122 comprise a corresponding structure of sufficiently insulating material, such as a structure of dielectric material 114. Example dielectric materials 114 for gate cut 122 include silicon nitride (SiN), silicon oxide (SiO), silicon carbide (SiC), silicon oxycarbide (SiOC), silicon oxycarbonitride (SiOCN), or silicon oxynitride (SiON), e.g., include silicon and one or more of oxygen, carbon, or nitrogen. In some cases, gate cuts 122 may include multiple layers of dielectric material, such as a first layer of high-k dielectric material along the outer sidewalls of the gate cut structure, and a second layer or body of low-k dielectric material that fills in the remaining portion of the gate cut 122. In some examples, the gate cut 122 may include one or more airgaps or voids (e.g., filled with gas such as oxygen and/or nitrogen, or devoid of gas). More generally, the gate cut 122 may include any number of dielectric layers or bodies, and the overall gate cut structure can vary from one embodiment to the next. In an example, since the gate cut 122 is formed after the formation of the gate structures, gate dielectric 116 are not present along the sidewalls of gate cut 122 within the gate trench.

According to some embodiments, the gate cut 122 also extends such that it may cut across a portion of source or drain contacts 138a, 138b, as illustrated in Fig. 1A. For example, prior to the formation of the gate cut 122, the source or drain contacts 138a, 138b may be a continuous and monolithic contact that is on both the source or drain regions 130a, 130b. However, the gate cut 122, in addition to extending or cutting through the gate structure 125 (see Fig. 1B), also extends through and cuts the continuous and monolithic contact 138 into two separate contacts 138a and 138b, as illustrated in Fig. 1A. For example, the gate cut process (e.g., to form the gate cut 122) may employ a non-selective etch process that not only cuts through the gate structure, but also cuts through the contact 138.

Thus, the gate cut 122 separates the contact 138a contacting the source or drain region 130a from the contact 138b contacting the source or drain region 130b. However, the circuit design may necessitate that the source or drain regions 130a and 130b be coupled to each other. Accordingly, as the gate cut separates the contacts 138a, 138b of the source or drain regions 130a, 130b, respectively, a bridge contact 140 is formed, as illustrated in Fig. 1A. Thus, the bridge contact 140 is used to conjoin and electrically couple the contacts 138a, 138b, which were severed during the gate cut formation process. The bridge contact 140 extends above the gate cut 122, and extends laterally from a top portion of the contact 138a to a top portion of the contact 138b, and electrically couples the two contacts 138a, 138b. Thus, the contact 138a extends vertically upward from the source or drain region 130a, the contact 138b extends vertically upward from the source or drain region 130b, and the contact 140 extends laterally from the contact 138a to the contact 138b, where the gate cut 122 comprising dielectric material 114 extends laterally between the contact 138a and the contact 138b, as illustrated in Fig. 1A. As illustrate in Fig. 1B, the gate cut 122 comprising dielectric material 114 also extends laterally between the gate structures 125a and 125b.

In one embodiment, a dielectric material 145 surrounds the source or drain regions 130a, 130b, and the contacts 138a, 138b, as illustrated in Fig. 1A. In an example, a dielectric material 147 is above the dielectric material 145, and the contact 140 extends within the dielectric material 147. In an example, a dielectric material 149 is above the dielectric material 147, and an interconnect feature 142, such as a conductive via, extends within the dielectric material 147. The interconnect feature 142 couples the contact 140 to one or more other interconnect features above the interconnect feature 142. The dielectric materials 145, 147, 149 may be an appropriate dielectric material, such as an interlayer dielectric (ILD), e.g., comprising silicon nitride (SiN), silicon oxide (SiO), silicon carbide (SiC), silicon oxycarbide (SiOC), silicon oxycarbonitride (SiOCN), or silicon oxynitride (SiON), e.g., include silicon and one or more of oxygen, carbon, or nitrogen. Although not illustrated in Fig. 1A, in an example, an etch stop layer may be between dielectric materials 145, 147, and/or an etch stop layer may be between dielectric materials 147, 149.

In an example, the conductive contacts 138a, 138b, 140, 142 comprise an appropriate conductive material, such as one or more metals and/or alloys. Examples include, but are not limited to, pure copper, ruthenium, molybdenum, tungsten, cobalt, titanium, aluminum, an alloy such as copper-tin (CuSn), copper indium (CuIn), copper-antimony (CuSb), copper-bismuth (CuBi), copper-rhenium (CuRe), and/or any other suitable conductive material. In some embodiments, the conductive contacts include one or more of the same metal materials as gate electrode, or a different conductive material. Although not illustrated, in one embodiment, suitable barrier, liner or encapsulation layer may at least in part be around the conductive fill material of the conductive contacts 138a, 138b, 140, 142, e.g., to prevent diffusion of the conductive fill material of a contact to adjacent dielectric material.

Fig. 1A also illustrates a magnified view of a section 170, which illustrates sections of the gate cut 122, the contact 138a, and the source or drain region 130a. Also illustrated is a liner or barrier layer 172 on sidewalls of portions of the contact 138a. In an example, the liner or barrier layer 172 is deposited prior to deposition of a conductive fill material of the contact 138a. The liner or barrier layer 172, in an example, prevents diffusion of the conductive material of the contact to adjacent dielectric material, facilitates better adhesion of the conductive material on walls of the contact, and/or may also facilitate in reducing contact resistance between the conductive fill material of the contact 138a and the source or drain region. Note that as the gate cut 122 is formed subsequent to the deposition of the liner or barrier layer 172, the liner or barrier layer 172 is not present along the gate cut sidewall. Suitable materials for the liner or barrier layer 172 include barrier layer refractory metals and alloys, cobalt, cobalt-nickel (CoNi), ruthenium-cobalt combination, molybdenum, nickel, manganese, titanium-tungsten (Ti ), tantalum (Ta), tantalum-nitride (TaN), tantalum-silicon-nitride (TaSiN), titanium-nitride (TiN), titanium-silicon-nitride (TiSiN), tungsten (XV), tungsten-nitride (WN), tungsten-silicon-nitride (WiSiN), and/or combinations of such materials (e.g., a multi-lay stack of Ta/TaN).

**Figs. 2A** and **2B** illustrate cross-sectional views of an integrated circuit structure 201 that includes a first portion that is similar to the integrated circuit structure 100 of Figs. 1A-1C, and also includes a second portion 200 comprising a continuous and monolithic source or drain contact 238 for two corresponding source or drain regions 230a, 230b, without any gate cut extending through the continuous and monolithic source or drain contact 238, according to an embodiment of the present disclosure.

The cross-sectional view of Fig. 2A is similar to that of Fig. 1A, and the cross-sectional view of Fig. 2B is similar to that of Fig. 1B. The structure 201 of Figs. 2A-2B include the structure 100 of Figs. 1A-1D, and also the structure 200. The structure 200 of Figs. 2A-2B is at least in part similar to the structure 100 of Figs. 1A-1D. For example, the structure 200 includes a source or drain region 230a and nanoribbons 204a of a device 201a, and another source or drain region 230b and nanoribbons 204b of a device 201b.

However, in the structure 100, a gate cut 122 extends through the gate structures of the devices 101a, 101b. In contrast, there is no gate cut extending though a gate structure of the devices 201a, 201b. Accordingly, a common gate structure 225 comprising a common and continuous gate electrode 218 is on (e.g., at least partially or fully wraps around) the nanoribbons 204a and 204b, as illustrated in Fig. 2B. Similarly, a common and monolithic source or drain contact 238 is on the source or drain regions 230a, 230b. Thus, because there is no gate cut extending through the gate structure 225, there is also no corresponding gate cut extending through the source or drain contact 238. Thus, while the structure 100 includes two contacts 138a, 138b for the source or drain regions 130a, 130b, respectively, there is a single and common contact 238 for both the source or drain regions 230a, 230b of the structure 200. Accordingly, unlike the structure 100 that includes the laterally extending bridge contact 140 between the disjoint contacts 138a, 138b, the structure 200 doesn't include such a laterally extending bridge contact. For example, in the structure 200, one or more conductive interconnect features 242 (such as a conductive via) extends through the dielectric material layers 147, 149, and contacts the contact 238 directly, without any bridge contact therebetween.

**Figs. 2C** and **2D** illustrate various cross-sectional views of an integrated circuit structure 200c is at least in part similar to the structure 100 of Figs. 1A-1D, and where the second contact 138b of the integrated circuit structure 200c of Figs. 2C and 2D extends vertically upward from a plurality of source or drain regions 130a, 230a, 230b, according to an embodiment of the present disclosure. Thus, similar to Figs. 1A-1D, the gate cut 122 extends laterally between the contacts 138a and 138b, and the bridge contact 140 couples the two contacts 138a and 138b. However, unlike the structure 100 of Figs. 1A-1D, in Figs. 2C and 2D the contact 138a extends vertically upward from a plurality of source or drain regions 130a, 230a, 230b of a corresponding plurality of devices 101a, 201a, 201b, respectively. The structure 200c will be apparent, based on the discussion of the structure 100 of Figs. 1A-1D.

**Fig. 3A** illustrate a cross-sectional view of an integrated circuit structure 300 that includes (i) a first source or drain region 130a, (ii) a first source or drain contact 138a in contact with the first source or drain region 130a, (iii) a second source or drain region 330a, (iv) a second source or drain contact 338a in contact with the second source or drain region 330a, wherein the first source or drain contact 138a is on a top surface and a side surface of the first source or drain region 130a, and wherein the second source or drain contact 338a is on only a top surface of the second source or drain region 330a, according to an embodiment of the present disclosure.

The structure 300 includes source or drain regions 130a, 130b, 330a, and 330b of adjacent devices 101a, 101b, 301a, and 301b, respectively. As discussed with respect to Figs. 1A-1D, the contacts 138a and 138b are in contact with the source or drain contacts 130a, 130b, respectively. Also, source or drain contacts 338a and 338b are in contact with the source or drain contacts 330a, 330b, respectively. As illustrated, a gate cut 114 extends laterally between the contacts 138a, 138b. However, there is no such gate cut extending between the contacts 338a, 338b.

The source or drain regions 130a, 130b are separated from each other by a distance L1, and similarly, the source or drain regions 330a, 330b are separated from each other by a distance L2, as illustrated in Fig. 3A. In an example, L1 is substantially equal to L2. In an example, the contacts 138a, 138b are on top and side surfaces of the respective source or drain regions 130a, 130b. For example, a long and continuous contact 138 is initially formed, which is then bifurcated or severed during the gate cut process, to yield the contacts 138a, 138b. In contrast, the contacts 338a, 338b are stand-along contacts and are (or were) not conjoined.

In one embodiment, the distance L2 may not be sufficient for the contacts 338a and/or 338b to respectively be on side surfaces of the source or drain regions 330a, 330b. For example, in the orientation of Fig. 3A, if the contact 338b is on a right side surface of the contact 330b and/or if the contact 338a is on a left side surface of the contact 330a, there may be chances of unintended electrical shorting between the contacts 338a and 338b. Accordingly, the contact 338a is formed on a top surface, but not on side surfaces of the source or drain region 330a; and similarly, the contact 338b is formed on a top surface, but not on side surfaces of the source or drain region 330b.

In contrast, the contact 138a is on side surfaces of the source or drain region 130a, and the contact 138b is on side surfaces of the source or drain region 130b. For example, the contacts 138a, 138b are anyway going to be conjoined or connected to form a single continuous contact 138, which is later severed or bifurcated by the gate cut 122 into two separate contacts 138a, 138b. Accordingly, the contact 138a may have a width of w1 on a side surface of the source or drain region 130a facing the source or drain region 130b (and similarly, the contact 138b may have a similar width on a side surface of the source or drain region 130b facing the source or drain region 130a).

Thus, a surface area of a bottom surface of a portion of each of the contacts 138a, 138b, which is on a sidewall of the corresponding source or drain regions, is substantially greater (e.g., at least 5%, or at least 10%, or at least 15%, or at least 20%, or at least 25%) than a bottom surface of a portion of the contacts 330a, 330b that is on the sidewalls of the corresponding source or drain regions. Note that in the example of Fig. 3A, no portion of the contacts 330a, 330b is on the sidewalls of the corresponding source or drain regions

For example, a left side of the contact 138a, which is on the left side surface of the source or drain contact 130a, has a first width w1; and a right side of the contact 138a, which is on the right side surface of the source or drain contact 130a, has a second width w2. In an example, the width w1 is substantially greater (e.g., at least 5%, or at least 10%, or at least 15%, or at least 20%, or at least 25%, or at least 1 nm, or at least 2 nm, or at least 4 nm, or at least 5 nm, or at least 7 nm, or at least 10 nm, or at least 12 nm) than the width w2.

Fig. 3A also illustrates an example magnified view of a section 370 of the structure 300. As illustrated, the portion of the contact 138b on a right side wall of the source or drain region 130b has a maximum width of w1, which is substantially greater than (e.g., at least 5%, or at least 10%, or at least 15%, or at least 20%, or at least 25%, or at least 1 nm, or at least 2 nm, or at least 4 nm, or at least 5 nm, or at least 7 nm, or at least 10 nm, or at least 12 nm) a width of a portion of the contact 138b on a left side wall of the source or drain region 130b.

Figs. 3B and 3C1 illustrate cross-sectional and plan views, respectively, of an integrated circuit structure 300b that includes (i) a first source or drain region 130a, (ii) a first source or drain contact 138a in contact with the first source or drain region 130a, (iii) a second source or drain region 330a, (ii) a second source or drain contact 338a in contact with the second source or drain region 330a, wherein a portion of the first source or drain contact 138a on side surfaces of the first source or drain contact 130a has a maximum width of w1, wherein a portion of the second source or drain contact 338b on side surfaces of the second source or drain contact 330b has a maximum width of w3, wherein the width w1 is substantially greater (e.g., at least 5%, or at least 10%, or at least 15%, or at least 20%, or at least 25%, or at least 1 nm, or at least 2 nm, or at least 4 nm, or at least 5 nm, or at least 7 nm, or at least 10 nm, or at least 12 nm) than the width w3, according to an embodiment of the present disclosure. Fig. 3C2 illustrates an alternate example plan view of the structure 300b of Fig. 3B, according to an embodiment of the present disclosure.

The plan views of Fig. 3C1 and 3C2 are along line M-M' of Fig. 3B, and illustrates top views of the source or drain regions 130a, 330b, and the contacts 138a, 338b. Various widths w1, w2, and w3 are illustrated in Figs. 3B and 3C.

Note that in an example, widths w2 and w3 can be zero, as illustrated in the example of Fig. 3C2. In the example of Fig. 3C1, widths w2 and w3 can be at most 1 nm, or at most 2 nm, or at most 3 nm. In contrast, the width w1 may be at least 1 nm, or at least 2 nm, or at least 3 nm, or at least 4 nm, or at least 5 nm, or at least 6 nm, or at least 7 nm, or at least 10 nm, or at least 12 nm. In an example, the width w1 may be greater than one or both of w2 and w3 by at least 1 nm, or at least 2 nm, or at least 3 nm, or at least 4 nm, or at least 5 nm, or at least 6 nm, or at least 7 nm, or at least 10 nm, or at least 12 nm. Note that width w3 is zero in the example of Figs. 3A and 3C2, and has a non-zero value in Figs. 3B and 3C1.

In the example of Figs. 3A-3C2, the contacts 138a, 138b are conjoined by the bridge contact 140. However, this may not necessarily be the case, as illustrated in Fig. 4A. Fig. 4 illustrates a cross-sectional view of an integrated circuit structure 400 that is at least in part similar to the integrated circuit structure 300b of Figs. 3B and 3C, wherein in the integrated circuit structure 400, a gate cut 122 is laterally between a first source or drain contact 438a and a second source or drain contact 438b, wherein the first source or drain contact 438a and the second source or drain contact 438b are not conjoined by a bridge contact, according to an embodiment of the present disclosure. Thus, the contacts 438a and 438b are electrically isolated in the structure 400. For example, the contacts 438a, 438b were initially (e.g., prior to the formation of the gate cut 122) conjoined to form a continuous and monolithic contact 438. Subsequently, the gate cut 122 is formed, thereby separating and electrically isolating the contacts 438a and 438b.

In the structure 100 of Figs. 1A-1D, the separated contacts 138a and 138b were later (e.g., after formation of the gate cut 122) conjoined and coupled through the bridge contact 140. In contrast, in the structure 400 of Fig. 4, the contacts 438a and 438b are kept separated, as no bridge contact is present.

In an example, the circuit design dictates that the contacts 438a and 438b are separated. So, the contacts 438a and 438b could have been formed similar to the contacts 338a and 338b (e.g., not conjoined even prior to the gate cut process). However, for reasons discussed with respect to Figs. 3A-3C, this would have meant that the contacts 438a, 438b doesn't adequately wrap at least in part around the source or drain regions 430a, 430b, respectively. Accordingly, a single and continuous contact 438 is initially formed, where the contact 438 adequately wraps at least in part around both the source or drain regions 430a, 430b (see width w1, by which the contact 438 wraps at least in part around the source or drain region 430a). Subsequently, the two contacts 438a and 438b are separated by the gate cut 144. Accordingly, in Fig. 4, the contacts 438a and 438b are stand-alone contacts (e.g., not coupled to any other contacts), and yet each of these contacts have adequate width (e.g., width w1) on at least one corresponding sidewall of the corresponding source or drain regions 430a and 430b, respectively. This decreases electrical resistance and results in better contact between the contact 438a and the source or drain region 430a, and also between the contact 438b and the source or drain region 430b, without corresponding increase in a capacitance. In an example, even if there is a marginal increase in the capacitance, the performance gains from the lower contact resistance outweighs any such increase in the capacitance.

**Fig. 5** illustrates a cross-sectional view of an integrated circuit structure 500 in which (i) a first source or drain contact 538a and a second source or drain contact 538b are laterally separated by a first gate cut 514a and conjoined by a bridge contact 540, (ii) a third source or drain contact 538c and a fourth source or drain contact 538d are laterally separated by a second gate cut 514b and are not conjoined by any bridge contact, and (iii) fifth and sixth source or drain contacts 338a, 338b that are not adjacent to a gate cut, according to an embodiment of the present disclosure.

For example, the contacts 538a, 538b are respectively above corresponding source or drain regions 530a, 530b, and are respectively similar to the corresponding contacts 138a, 138b of Figs. 1A-1D. The contacts 538c, 538d are respectively above corresponding source or drain regions 530c, 530d, and are respectively similar to the corresponding contacts 438a, 438b of Fig. 4.

Note that each of the contacts 538a, 538b, 538c, and 538d have a corresponding portion of a corresponding sidewall of the corresponding source or drain region, where the portion has a width of w1, as illustrated in Fig. 4, and as also discussed with respect to Figs. 3A-3C and 4. This decreases electrical resistance and results in better contact between individual ones of the contacts 538a, 538b, 538c, and 538d and the corresponding source or drain region, without a corresponding increase in capacitance of the contacts. The structure 500 will be apparent based on the discussion above with respect to Figs. 1A-4.

**Fig. 6** illustrates a flowchart depicting a method 600 of forming any of the integrated circuit structures of Figs. 1A-5, in accordance with an embodiment of the present disclosure. **Figs. 7A, 7B, 7C****,** **7D, 7E, 7F****,** **7G, 7H**, 7I, and 7I1 collectively illustrate cross-sectional views of an integrated circuit structure in various stages of processing in accordance with the methodology 600 of Fig. 6, in accordance with an embodiment of the present disclosure. Figs. 6 and 7A-7I1 will be discussed in unison.

Referring to Fig. 6, the method 600 includes, at 604, forming devices 701a, 701b, 701c, 701d, without forming any source or drain contacts of the devices, where dielectric material 745 is at least above source or drain regions 730a, 730b, 730c, 730d, respectively, of the devices 701a, 701b, 701c, 701d, as illustrated in Fig. 7A. The devices 701a, ..., 701d may be formed using appropriate techniques for forming such devices.

The method 600 then proceeds from 604 to 608. At 608, recesses 710, 712, and 714 are formed within the dielectric material 745, as illustrated in Fig. 7B. The recess 710 extends above the source or drain regions 730c, 730d, the recess 712 extends above the source or drain region 730b, and the recess 714 extends above the source or drain region 730a. Note that as the recess 710 extends above both the contacts 730d, 730c, the recess 710 at least in part wraps around one or more sidewalls of the corresponding source or drain regions 730c, 730d, as illustrated in Fig. 7B. The recesses can be formed using any appropriate masking and etching techniques for forming such recesses.

The method 600 then proceeds from 608 to 612. At 612, the recesses 710, 712, 714 are filled with conductive material, to respectively form the source or drain contacts 738, 748b, 748a. As illustrated in Fig. 7C and as discussed herein above, substantial portion of the contacts 738 is on sidewalls of the source or drain regions 730c, 730d.

The method 600 then proceeds from 612 to 616. At 616, a recess 720 is formed, where the recess 720 extends through a gate structure of the devices 701c, 701d, and also extends though the source or drain contact 738, thereby bifurcating the source or drain contact 738 into separate contacts 738a, 738b. For example, Fig. 7D illustrates the recess 720 extending though the source or drain contact 738. Also at 616, the recess 720 is filled with dielectric material 714, to form the gate cut 722, as illustrated in Fig. 7E. For example, Fig. 7E illustrates the gate cut 722 extending laterally between the contacts 738a, 738b. Various figures (e.g., Fig. 1B) discussed herein above illustrate a gate cut extending between gate structures of two devices.

The method 600 then proceeds from 616 to either of 620a or 620b. For example, process 620a results in the structures illustrated in Figs. 7F, 7G, 7H, and 7I, e.g., which is at least in part similar to the structures illustrated in Figs. 2A, 2B, 3A-3C2 (and also at least in part similar to the structures illustrated in Figs. 1A-1D). On the other hand, process 620b results in the structure illustrated in Fig. 7I1, e.g., which is at least in part similar to the structure illustrated in Fig. 4. Any of the processes 620a or 620b is performed, depending on a desired end structure. As will be appreciated, the processes 620a and/or 620b can be appropriately modified, to form any of the structures illustrated in Figs. 1A-5.

Referring now to 620a of the method 600, a bridge contact 740 is formed, where the bridge contact 740 couples the contacts 738a, 738b, as illustrated in Figs. 7F, 7G, and 7H. Also at 620a, a conductive structure 742a coupled to the bridge contact 740 and another conductive structure 742b coupled to the contact 748b are formed, as illustrated in Fig. 7I. For example, in Fig. 7F, a layer 147 comprising dielectric material is formed above the contacts 738a, 738b, 748a, 748b. As illustrated in Fig. 7G, recesses 724 and 726 are formed within the dielectric material layer 147, where the recess 724 is above the contacts 738a and 738b, and the recess 726 is above the contact 748b. At Fig. 7H, the recesses 724 and 726 are filled with conductive material (such as one or more metals and/or alloys thereof, as discussed herein above), to respectively form the contacts 740 and 742a. Subsequently, as illustrated in Fig. 7I, another dielectric material layer 149 is deposited above the structure of Fig. 7H, and conductive contacts 742a and 742b are formed within the dielectric material layer 149.

Referring now to 620b (which may be performed as an alternative to 620a) of the method 600, conductive contacts 752a, 752b, 742b are formed, which are respectively coupled to the contacts 738a, 738b, 748b, as illustrated in Fig. 7I1. For example, a dielectric material layer 147 is deposited above the structure of Fig. 7E, and conductive contacts 752a, 752b, 742b are formed within the dielectric material layer 149, see Fig. 7I1.

Thus, while the structure of Fig. 7I includes the bridge contact 740 coupling the contacts 738a and 738b, the structure of Fig. 7I1 lacks such a bridge contact. Thus, in the structure of Fig. 7I1, the contacts 738a and 738b are not coupled to each other.

Note that the processes in method 600 are shown in a particular order for ease of description. However, one or more of the processes may be performed in a different order or may not be performed at all (and thus be optional), in accordance with some embodiments. Numerous variations on method 600 and the techniques described herein will be apparent in light of this disclosure.

### Example System

**Fig.** 8 illustrates a computing system 1000 implemented with integrated circuit structures formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), nonvolatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multi-standard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following examples pertain to further embodiments, from which numerous permutations and configurations will be apparent.
Example 1. An integrated circuit comprising: a first device including (i) a first source or drain region, (ii) a first body of semiconductor material extending laterally from the first source or drain region, (iii) a first gate structure on the first body, and (iv) a first contact extending vertically upward from the first source or drain region; a second device including (i) a second source or drain region, (ii) a second body of semiconductor material extending laterally from the second source or drain region, (iii) a second gate structure on the second body, and (iv) a second contact extending vertically upward from the second source or drain region; a gate cut structure comprising dielectric material laterally between the first gate structure and the second gate structure, and also laterally between the first contact and the second contact; and a third contact extending laterally from the first contact to the second contact and over the gate cut structure.
Example 2. The integrated circuit of claim 1, wherein the third contact extends laterally from an upper surface of the first contact to an upper surface of the second contact.
Example 3. The integrated circuit of any one of claims 1-2, further comprising: a third device including (i) a third source or drain region, and (ii) a third body of semiconductor material extending laterally from the third source or drain region, wherein the first gate structure is on the third body, and wherein the first contact extends vertically upward from the third source or drain region.
Example 4. The integrated circuit of any one of claims 1-2, further comprising: a third device including (i) a third source or drain region, (ii) a third body of semiconductor material extending laterally from the third source or drain region, (iii) a third gate structure on the third body, and (iv) a fourth contact extending vertically upward from the third source or drain region; wherein a portion of the first contact, which is on a sidewall of the first source or drain region, has a first width; and wherein a portion of the fourth contact, which is on a sidewall of the third source or drain region, has a second width that is at least 2 nanometers less than the first width.
Example 5. The integrated circuit of any one of claims 1-4, wherein: the first source or drain region has a first sidewall facing the second source or drain region, and a second sidewall that is on an opposite side of the first sidewall; a first portion of the first contact, which is on the first sidewall of the first source or drain region, has a first width; and a second portion of the first contact, which is on the second sidewall of the first source or drain region, has a second width that is at least 2 nanometers less than the first width.
Example 6. The integrated circuit of any one of claims 1-5, wherein the second width is at least 5 nanometers less than the first width.
Example 7. The integrated circuit of any one of claims 1-6, wherein: the first source or drain region has a first sidewall facing the second source or drain region, and a second sidewall that is on an opposite side of the first sidewall; a portion of the first contact is on the first sidewall of the first source or drain region; and no portion of the first contact is on the second sidewall of the first source or drain region.
Example 8. The integrated circuit of any one of claims 1-7, wherein each of the first body and the second body is a nanoribbon, a nanosheet, or a nanowire.
Example 9. The integrated circuit of any one of claims 1-8, wherein each of the first body and the second body is a fin.
Example 10. The integrated circuit of any one of claims 1-9, wherein the gate cut structure is also laterally between the first source or drain region and the second source or drain region.
Example 11. The integrated circuit of any one of claims 1-10, wherein the gate cut structure is a continuous structure of the dielectric material that is laterally between the first gate structure and the second gate structure, and also laterally between the first contact and the second contact
Example 12. The integrated circuit of any one of claims 1-11, wherein the first contact comprises: conductive fill material; and a conductive liner layer of one or more walls of the first contact.
Example 13. The integrated circuit of claim 12, wherein the conductive liner layer is present between the conductive fill material of the first contact and at least a section of the first source or drain region, and the conductive liner layer is absent between the conductive fill material of the first contact and at least a section of the gate cut structure.
Example 14. A printed circuit board comprising the integrated circuit of any one of claims 1-13.
Example 15. An integrated circuit comprising: a first device including (i) a first source or drain region, (ii) a first gate structure, and (iii) a first contact extending above from the first source or drain region; a second device including (i) a second source or drain region, (ii) a second gate structure, and (ii) a second contact extending above from the second source or drain region; a third device including (i) a third source or drain region, (ii) a third gate structure, and (ii) a third contact extending above from the third source or drain region; and gate cut comprising dielectric material laterally between the first gate structure and the second gate structure, and also laterally between the first contact and the second contact; wherein a portion of the first contact that is on a sidewall of the first source or drain region has a first width; wherein a portion of the third contact that is on a sidewall of the third source or drain region has a second width; and the first width is greater than the second width by at least 2 nanometers.
Example 16. The integrated circuit of claim 15, wherein the second width is less than 1 nm.
Example 17. The integrated circuit of any one of claims 15-16, wherein the first width is greater than the second width by at least 4 nanometers.
Example 18. The integrated circuit of any one of claims 15-17, wherein: the portion of the first contact having the first width is a first portion; the sidewall of the first source or drain region, on which the first portion of the first contact having the first width is located, is a first sidewall of the first source or drain region; the first sidewall of the first source or drain region faces the gate cut and the second source or drain region; the first source or drain region has a second sidewall opposite the first sidewall; a second portion of the first contact that is on the second sidewall of the first source or drain region has a third width; and the first width is greater than the third width by at least 2 nanometers.
Example 19. The integrated circuit of any one of claims 15-18, wherein: the sidewall of the first source or drain region, on which the portion of the first contact having the first width is located, is a first sidewall of the first source or drain region; the first sidewall of the first source or drain region faces the gate cut and the second source or drain region; the first source or drain region has a second sidewall opposite the first sidewall; and no portion of the first contact is on the second sidewall of the first source or drain region.
Example 20. The integrated circuit of any one of claims 15-19, further comprising: a fourth contact extending laterally from an upper surface of the first contact to an upper surface of the second contact, wherein the fourth contact is above a portion of the gate cut.
Example 21. An integrated circuit comprising: a first source or drain region, and a first contact that is in contact with top and side surfaces of the first source or drain region; a second source or drain region, and a second contact that is in contact with top and side surfaces of the second source or drain region; and a gate cut structure extending laterally between the first contact and the second contact; and wherein each of the side surface of the first source or drain region and the side surface of the second source or drain region are facing the gate cut structure.
Example 22. The integrated circuit of claim 21, further comprising: a conductive structure extending laterally from an upper surface of the first contact to an upper surface of the second contact, the conductive structure extending above the gate cut structure.
Example 23. The integrated circuit of any one of claims 21-22, further comprising: a first body of semiconductor material extending laterally from the first source or drain region, and a first gate structure on the first body; a second body of semiconductor material extending laterally from the second source or drain region, and a second gate structure on the second body; wherein the gate cut structure extends laterally between the first gate structure and the second gate structure.
Example 24. The integrated circuit of any one of claims 21-23, wherein: the first source or drain region has a first sidewall facing the second source or drain contact, and an opposing second sidewall; a first portion of the first contact, that is on the first sidewall of the first source or drain region, has a first width; a second portion of the first contact, that is on the second sidewall of the first source or drain region, has a second width; and the first width is greater than the second width by at least 2 nanometers.

The foregoing description of example embodiments of the present disclosure has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto.

## Claims

1. An integrated circuit comprising:
a first device including (i) a first source or drain region, (ii) a first body of semiconductor material extending laterally from the first source or drain region, (iii) a first gate structure on the first body, and (iv) a first contact extending vertically upward from the first source or drain region;
a second device including (i) a second source or drain region, (ii) a second body of semiconductor material extending laterally from the second source or drain region, (iii) a second gate structure on the second body, and (iv) a second contact extending vertically upward from the second source or drain region;
a gate cut structure comprising dielectric material laterally between the first gate structure and the second gate structure, and also laterally between the first contact and the second contact; and
a third contact extending laterally from the first contact to the second contact and over the gate cut structure.

2. The integrated circuit of claim 1, wherein the third contact extends laterally from an upper surface of the first contact to an upper surface of the second contact.

3. The integrated circuit of claim 1 or 2, further comprising:
a third device including (i) a third source or drain region, and (ii) a third body of semiconductor material extending laterally from the third source or drain region,
wherein the first gate structure is on the third body, and
wherein the first contact extends vertically upward from the third source or drain region.

4. The integrated circuit of claim 1 or 2, further comprising:
a third device including (i) a third source or drain region, (ii) a third body of semiconductor material extending laterally from the third source or drain region, (iii) a third gate structure on the third body, and (iv) a fourth contact extending vertically upward from the third source or drain region;
wherein a portion of the first contact, which is on a sidewall of the first source or drain region, has a first width; and
wherein a portion of the fourth contact, which is on a sidewall of the third source or drain region, has a second width that is at least 2 nanometers less than the first width.

5. The integrated circuit of any one claims 1 through 4, wherein:
the first source or drain region has a first sidewall facing the second source or drain region, and a second sidewall that is on an opposite side of the first sidewall;
a first portion of the first contact, which is on the first sidewall of the first source or drain region, has a first width; and
a second portion of the first contact, which is on the second sidewall of the first source or drain region, has a second width that is at least 2 nanometers less than the first width.

6. The integrated circuit of any one claims 1 through 5, wherein the second width is at least 5 nanometers less than the first width.

7. The integrated circuit of any one claims 1 through 6, wherein:
the first source or drain region has a first sidewall facing the second source or drain region, and a second sidewall that is on an opposite side of the first sidewall;
a portion of the first contact is on the first sidewall of the first source or drain region; and
no portion of the first contact is on the second sidewall of the first source or drain region.

8. The integrated circuit of any one claims 1 through 7, wherein each of the first body and the second body is a nanoribbon, a nanosheet, or a nanowire.

9. The integrated circuit of any one of claims 1-7, wherein each of the first body and the second body is a fin.

10. The integrated circuit of any one claims 1 through 9, wherein the gate cut structure is also laterally between the first source or drain region and the second source or drain region.

11. The integrated circuit of any one claims 1 through 10, wherein the gate cut structure is a continuous structure of the dielectric material that is laterally between the first gate structure and the second gate structure, and also laterally between the first contact and the second contact.

12. The integrated circuit of any one claims 1 through 10, wherein the gate cut structure includes a first layer of high-k dielectric material along outer sidewalls of the gate cut structure, and a second layer of low-k dielectric material that fills in a remaining portion of the gate cut structure.

13. The integrated circuit of any one claims 1 through 12, wherein the first contact comprises:
conductive fill material; and
a conductive liner layer of one or more walls of the first contact.

14. The integrated circuit of claim 13, wherein the conductive liner layer is present between the conductive fill material of the first contact and at least a section of the first source or drain region, and the conductive liner layer is absent between the conductive fill material of the first contact and at least a section of the gate cut structure.

15. A printed circuit board comprising the integrated circuit of any one of claims 1-14.
